# EUROPÄISCHE PATENTSCHRIFT

(11) **EP 1 556 910 B1**
(45) Veröffentlichungstag und Bekanntmachung des Hinweises auf die Patenterteilung: **26.05.2010**
(21) Anmeldenummer: 03785496.5
(22) Anmeldetag: 29.10.2003
(51) Int. Cl.: H01L 51/05

(54) **VERFAHREN ZUR HERSTELLUNG EINES FELDEFFEKTTRANSISTORS**
METHOD FOR PRODUCING A FIELD EFFECT TRANSISTOR
PROCEDE DE FABRICATION D'UN TRANSISTOR A EFFET DE CHAMP

(30) Priorität: 29.10.2002 DE 10250984
(43) Veröffentlichungstag der Anmeldung: 27.07.2005
(73) Patentinhaber: Helmholtz-Zentrum Berlin für Materialien und Energie GmbH, 14109 Berlin (DE)
(72) Erfinder: KÖNENKAMP, Rolf, Portland, OR 97201 (US)
(74) Vertreter: Hoffmann, Heinz-Dietrich
(86) Internationale Anmeldenummer: PCT/DE2003/003673
(87) Internationale Veröffentlichungsnummer: WO 2004/040616

(56) Entgegenhaltungen:
- DE-C- 10 036 897
- US-A1- 2002 001 905
- US-B1- 6 515 325
- ENGELHARDT R ET AL: "Growth of compound semiconductors in nanometer sized channels of polymers" 2001, WARRENDALE, PA, USA, MATER. RES. SOC, USA, 17. April 2001 (2001-04-17), - 20. April 2001 (2001-04-20) Seiten O8.8.1-6, XP008030799 ISBN: 1-55899-608-7

## Beschreibung

Die Erfindung betrifft ein Verfahren zur Herstellung eines Feldeffekttransistors, bei dem sich zwischen einem Source- und einem Drainkontakt mindestens eine vertikal ausgerichtete Halbleitersäule mit einem Durchmesser im Nanometerbereich (Nano-wire) befindet, die unter Belassung eines Isolationsabstandes ringförmig von einem Gatekontakt umgeben ist.

Bekannt sind Dünnschichttransistoren, bei denen Halbleitermaterial in planarer Anordnung auf flexiblle Substrate aufgebracht wird. Durch mechanische Beanspruchung der Substrate kommt es jedoch leicht zum Ablösen der Halbleiter von dem Substrat oder zu anderen Beschädigungen und damit zum Funktionsausfall.

Bekannt sind auch Feldeffekttransistoren (DE 100 36 897 C1) mit vertikal angeordneten Halbleitersäulen mit einem Durchmesser im Nanometerbereich, die unter Belassung eines Isolationsabstandes ringförmig von einem Gatekontakt umgeben sind.

Es ist bereits vorgeschlagen worden, Transistoren im Nanometermaßstab herzustellen, indem in einen aus zwei Kunststofffolien und zwischenliegender Metallschicht bestehenden Folienverbund mittels Ionenbeschuss Ionenspurkanäle eingebracht werden, die so für eine nachfolgende Ätzung sensitiviert werden. In die herausgeätzten Mikrolöcher wird mittels Elektrodeposition oder chemischer Badabscheidung Halbleitermaterial eingebracht. Durch anschließendes Metallisieren der Ober- und Unterseite des Folienverbundes werden Source- und Drainkontakte gebildet. Die mittige Metallschicht dient als Gatekontakt.

Die zylinderische, vertikale Anordnung dieser Transistoren hat den Vorteil, dass sie mechanisch sehr robust sind, da die Folie biegbar oder dehnbar ist. Das organische Folienmaterial ist zudem wesentlich weicher als das anorganische Halbleitermaterial. Dadurch werden auftretende Biege-, Scher- und Druckkräfte fast vollständig vom Folienmaterial aufgenommen, so dass die Transistorkennlinie und andere elektrische Parameter weitgehend konstant unter Biege-, Flex- und Zugkräften sind.

Da die Mikrolöcher bis hinunter zu 30 nm hergestellt und mit Halbleitermaterial aufgefüllt werden können, lassen sich Transistoren im Nanometer-Maßstab auch ohne Lithographie und ohne Maskentechnik herstellen.

Durch die Art der Abscheidung des Halbleitermaterials bedingt entstehen bei dem Verfahren polykristallin Halbleitersäulen. Auch das Verhältnis von Länge zu Durchmesser der Halbleitersäulen ist durch das nötige Kristallwachstum innerhalb der Mikrolöcher beschränkt. Insgesamt ist das Verfahren zur Herstellung der Transistoren noch zu aufwendig, da der Ionenbeschuss bisher nur in ausgewählten wissenschaftlichen Einrichtungen vorgenommen werden kann.

Der Erfindung liegt die Aufgabe zugrunde, ein einfaches, industriell anwendbares Verfahren zur Herstellung eines Feldeffekttransistors der eingangs genannten Art anzugeben, der auch mit monokristallinen Halbleitersäulen herstellbar ist, wobei ohne Ionenbestrahlung ausgekommen werden soll.

Erfindungsgemäß wird die Aufgabe gelöst durch die Merkmale des Anspruchs 1. Zweckmäßige Ausgestaltungen sind Gegenstand der Unteransprüche.

Danach kann ein Transistor, bei dem Halbleitersäulen in eine erste und eine zweite Isolierschicht eingebettet sind, sich zwischen diesen Isolierschichten eine als Gatekontakt nach außen geführte Metallschicht befindet und die nach oben durch die zweite Isolierschicht hindurchtretenden Enden der Metallschicht teilweise in einen Isolator umgewandelt oder teilweise entfernt und durch ein Isoliermaterial aufgefüllt sind, mit folgenden Verfahrensschritten hergestellt werden:
- zunächst werden auf ein leitfähiges Substrat freistehende Halbleitersäulen vertikal aufgewachsen,
- auf diese Halbleitersäulen wird dann eine erste Isolierschicht aufgebracht,
- auf die anschließend eine erste leitende Metallschicht und eine zweite Isolierschicht aufgebracht wird,
- dann wird der entstandene Schichtkörper so weit plangeätzt, dass der die Halbleitersäulen bedeckende Anteil der ersten Metallschicht wieder entfernt wird,
- danach werden die Enden der zur Oberfläche des Schichtkörpers hindurchtretenden Metallschicht metallspezifisch zurückgeätzt und auf den Schichtkörper wird eine dritte Isolierschicht aufgebracht, worauf der Schichtkörper erneut plangeätzt wird,
   oder
   die Enden der zur Oberfläche des Schichtkörpers hindurchtretenden Metallschicht werden durch Oxidation oder Nitridierung in einen Isolator umgewandelt,
- und auf den Schichtkörper wird abschließend eine zweite Metallschicht aufgebracht.

Der mit dem Verfahren hergestellte Transistor weist gegenüber bisherigen vertikalen Nanotransistoren folgende Vorteile auf:
- Die Struktur des Feldeffekttransistors erlaubt eine extrem hohe Packungsdichte und extrem kleine Abmessungen ohne dass lithographische Methoden angewendet werden müssten.
- Die verwendeten Substrate können fest oder flexibel sein.
- Zur Herstellung sind nicht unbedingt Ionenstrahlen notwendig.
- Das Verfahren erlaubt es nunmehr auch, die Halbleitersäulen monokristallin wachsen zu lassen. Transistoren auf der Grundlage monokristalliner Halbleiter weisen höhere Schaltgeschwindigkeiten auf als solche mit polykristallinen Halbleitern.

Die Erfindung wird im Folgenden anhand von Ausführungsbeispielen näher erläutert. In den dazugehörigen Zeichnungen zeigen
- Fig. 1: den ersten Verfahrensschritt zur Herstellung eines erfindungsgemäßen Feldeffekttransistors - Aufwachsen der freistehenden Halbleitersäulen auf einem metallisch leitenden Substrat,
- Fig. 2: den zweiten Verfahrensschritt - Aufbringen einer ersten Isolierschicht,
- Fig. 3: den dritten und vierten Verfahrensschritt - Aufbringen einer ersten Metallschicht und einer zweiten Isolierschicht,
- Fig. 4: den fünften Verfahrensschritt - Planätzen,
- Fig. 5: den sechsten Verfahrensschritt - Isolieren der nach oben durchragenden Enden der Metallschicht,
- Fig. 6: den siebenten Verfahrensschritt - Aufbringen einer zweiten Metallschicht, fertige Struktur des Transistors im Querschnitt
- Fig. 7: ein mit dem Verfahren herstellbares Transistorarray im Querschnitt.

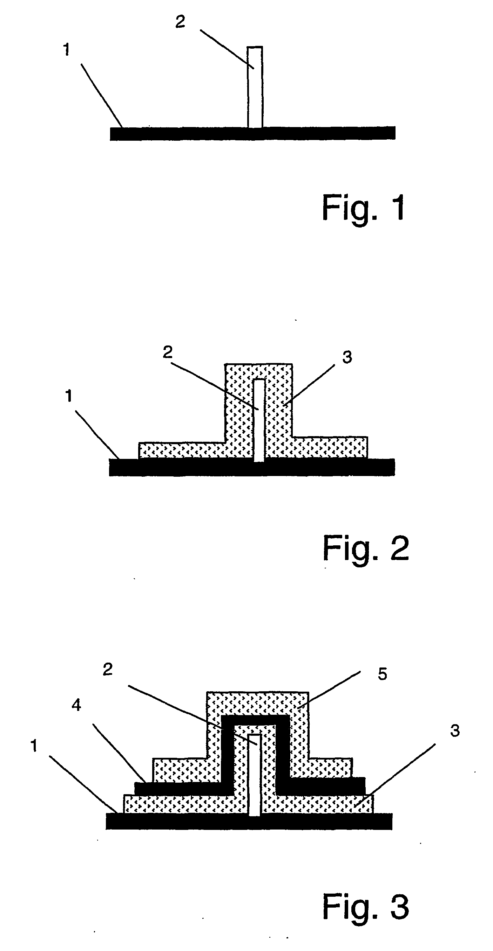

Wie Fig. 1 zeigt, werden auf ein leitendes Substrat **1,** das flexibel oder fest sein kann, zunächst vertikal freistehende Halbleitersäulen **2** aufgewachsen. Hierzu kann ein ungeordneter Prozess genutzt werden, wie er etwa von dem elektrochemischen Wachstum von ZnO-Säulen aus /1/ bekannt ist. Alternativ dazu könnte auch ZnO durch Verdampfen von Zn oder ZnO aufgebracht werden, siehe /2/. Man kann aber auch ein Substrat so vorpräparieren, dass in geordneter oder ungeordneter Weise Nukleationskeime entstehen, an denen das Säulenwachstum beginnt. Als ungeordnete Nukleationskeime lassen sich z.B. Ni-dots für das Wachstum von ZnO-Säulen /2/ oder Ni-dots für das vertikale Wachstum von C60-Nanoröhren nutzen, siehe /3/, Fig. d. Geordnete Nukleationskeime können durch lithographische Methoden erzeugt werden, siehe /3/ oder durch nichtlithographische, zum Beispiel durch Versetzungsstufen an fehlausgerichteten Kristallflächen. Im Fall von nichtlithographisch erzeugten Nukleationskeimen entfallen weitgehend die durch die Lithographie gegebenen Größenbeschränkungen. Das Säulenwachstum ist nur durch die Größe des Nukleationskeimes vorgegeben. Halbleitersäulen können aber auch in geätzten Ionenspurkanälen von Polymerfilmen hergestellt werden. Wenn anschließend das Folienmaterial entfernt wird, entstehen ebenfalls freistehende Halbleitersäulen, siehe /4/.

Die auf Substraten gewachsenen Halbleitersäulen (Nanofibers/Nanotubes) haben bisher hauptsächlich Bedeutung erlangt für den Aufbau von Bauelementen zur Etektronenfeldemission, Lumineszenzdioden und Solarzellen mit extrem dünner Absorberschicht.

Neben den vorgenannten Materialien für die Halbleitersäulen kommen auch Materialien wie GaP, siehe /5/, InAs, InP, CdTe und andere in Frage.

Nach dem Aufwachsen der Halbleitersäulen **2** wird eine Isolierschicht **3** aufgebracht, wie in Fig. 2 gezeigt ist. Das Aufbringen kann durch Spin-Coaten eines Polymers oder durch Verdampfen, CVD (Chemical Vapor Deposition) oder andere bekannte Verfahren zum Erzeugen einer Isolierschicht, wie etwa einem Oxid oder Nitrid, erfolgen.

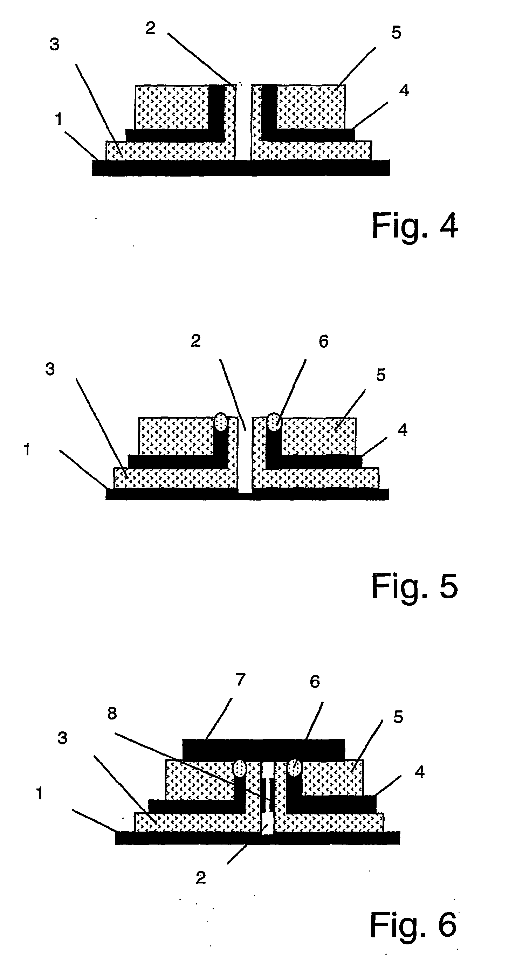

Die Isolierschicht **3** bedeckt auch die Seitenflächen der Halbleitersäulen **1.** Auf die Isolierschicht **3** wird durch Sputtern, Verdampfen, CVD oder ein ähnliches Verfahren eine erste leitende Metallschicht **4** aufgebracht, die später den Gatekontakt des Transistors bildet. Anschließend wird eine weitere Isolierschicht **5** aufgetragen (Fig. 3) und der obere Teil des so entstandenen Schichtkörpers plangeätzt (Fig. 4). Dies kann durch einen horizontalen Ionenstrahl erfolgen (Ionenstrahlätzen) oder durch Plasma- oder chemische bzw. elektrochemische Ätzverfahren, wie sie aus der Halbleitertechnologie hinreichend bekannt sind. Anschließend werden die aus der Schichtfolge nach oben durchtretenden Enden der Metallschicht **4** isoliert (Fig. 5). Das kann erfolgen, indem in einem metallspezifischen Ätzschritt das an die Oberfläche tretende Metall zurückgeätzt wird und eine weitere Isolierschicht aufgebracht wird, die darauf wieder planarisiert wird. Alternativ dazu kann, wie in Fig. 5 angedeutet ist, das an die Oberfläche tretende Metall durch eine chemische Oxidation oder Nitridierung in einen Isolator **6** umgewandelt werden. Abschließend wird eine zweite Metallschicht **7** aufgebracht (Fig. 6). Diese Metallschicht ist in elektrischem Kontakt mit der Halbleitersäule und wirkt später als Source- oder Drainkontakt.

Im Bereich des mittleren Kontaktes, der als Gatekontakt wirkt, entsteht auf der Außenseite der Halbleitersäule **2** ein Channel **8,** der sich, wenn die Halbleitersäule **2** dünn genug ist, auch über die gesamte Dicke der Säule erstrecken kann.

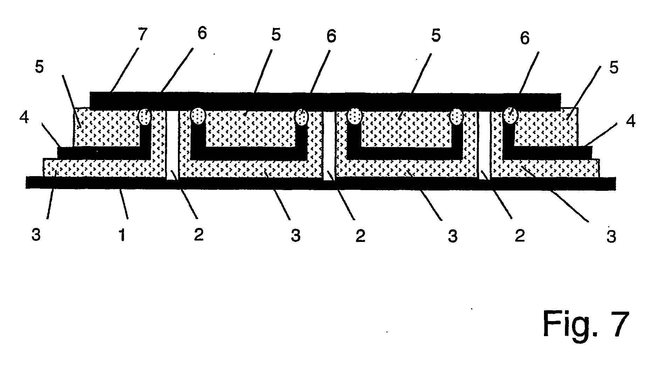

In Fig. 7 ist ein Transistor-Array dargestellt. Der Gatekontakt umgibt die Halbleitersäulen **2** jeweils ringförmig und ist somit im Ganzen zusammenhängend. Alle Kontakte (Source, Drain, Gate) können als Array angesteuert werden oder mittels lithographischer Methoden unterteilt werden. Derartige Arrays lassen sich insbesondere in Schaltkreisen oder Displays verwenden. Bei Displays werden einige Hundert Transistoren zu einem optischen Pixel zusammengefasst.

Mit dem Verfahren ist die Herstellung von Transistoren mit Halbleitersäulen in der Größenordnung von 10 bis 500 nm Durchmesser möglich. Die Höhen der Halbleitersäulen liegen in demselben Bereich. Bei sehr kleinen Durchmessem kann der Transistor im Quantenregime betrieben werden.

### Liste der zitierten Literaturstellen

/1/ Thin Film Deposition on Free-standing ZnO Columns, Könenkamp et al., Appl. Phys. Lett. 77. No 16 (16. October 2000), 2275-2277
/2/ Seung Chu Lyu et al., Low Temperature Growth of Zno Nano-wire Array Using Vapour Deposition Method, Chemistry of Materials to be published
/3/ Teo et al., NanotechConference, Santiago de Compostela, September 9-13, 2002-10-09
/4/ Engelhardt, Könenkamp, Electrodeposition of Compound Semiconductors in Polymer Channels of 100nm Diameter, J. Appl. Phys., 90, No 8 (15. October 2002), 4287-4289
/5/ Gudiksen/Lieber, Diameter-Selective Semiconductor Nanowires, J. Am. Chem. Soc. 122 (2000), 8801-8802

### Liste der verwendeten Bezugszeichen

- 1: Substrat
- 2: Halbleitersäule
- 3: Isolierschicht
- 4: Metallschicht
- 5: Isolierschicht
- 6: Isolator
- 7: Metallschicht
- 8: Channel

## Patentansprüche

1. Verfahren zur Herstellung eines Feldeffekttransistors, bei dem sich zwischen einem Source- und einem Drainkontakt mindestens eine vertikal ausgerichtete Halbleitersäule mit einem Durchmesser im Nanometerbereich befindet, die unter Belassung eines Isolationsabstandes ringförmig von einem Gatekontakt umgeben ist,
**dadurch gekennzeichnet, dass**
- zunächst auf ein leitfähiges Substrat (1) freistehende Halbleitersäulen (2) vertikal aufgewachsen werden,
- auf diese Halbleitersäulen (2) dann eine erste Isolierschicht (3) aufgebracht wird,
- auf die anschließend eine erste leitende Metallschicht (4) und eine zweite Isolierschicht (5) aufgebracht wird,
- dann der entstandene Schichtkörper so weit plangeätzt wird, dass der die Halbleitersäulen (2) bedeckende Anteil der ersten Metallschicht (4) wieder entfernt wird,
- danach die Enden der zur Oberfläche des Schichtkörpers hindurchtretenden Metallschicht (4) metallspezifisch zurückgeätzt werden und auf den Schichtkörper eine dritte Isolierschicht aufgebracht wird, worauf der Schichtkörper erneut plangeätzt wird,
oder
die Enden der zur Oberfläche des Schichtkörpers hindurchtretenden Metallschicht (4) durch Oxidation oder Nitridierung in einen Isolator (6) umgewandelt werden,
- und auf den Schichtkörper abschließend eine zweite Metallschicht (7) aufgebracht wird.

2. Verfahren nach Anspruch 1,
**dadurch gekennzeichnet, dass**
der Schichtkörper oder einzelne Schichten mittels einer lithographischen Methode in einzelne Arrays unterteilt wird.

3. Verfahren nach Anspruch ,1 oder 2,
**dadurch gekennzeichnet, dass**
das Aufwachsen der Halbleitersäulen elektrochemisch erfolgt.

4. Verfahren nach Anspruch 1 oder 2,
**dadurch gekennzeichnet, dass**
das Aufwachsen der Halbleitersäulen durch Sputtern erfolgt.

5. Verfahren nach Anspruch 1 oder 2,
**dadurch gekennzeichnet, dass**
das Aufwachsen der Halbleitersäulen durch ein CVD-Verfahren erfolgt.

6. Verfahren nach Anspruch 1 oder 2,
**dadurch gekennzeichnet, dass**
das Aufwachsen der Halbleitersäulen durch Verdampfen erfolgt.

7. Verfahren nach Anspruch 1 oder 2,
**dadurch gekennzeichnet, dass**
das Aufwachsen der Halbleitersäulen auf Nukleationskeimen erfolgt.

8. Verfahren nach Anspruch 1 oder 2,
**dadurch gekennzeichnet, dass**
das Aufwachsen der Halbleitersäulen in Ionenspurkanälen einer Polymerfolie erfolgt, die anschließend wieder entfernt wird.

## Claims

1. A method of fabricating a field effect transistor in which at one vertically aligned semiconductor column of a diameter in the nanometer rang is present between a source electrode and a drain electrode and is annularly surrounded by a gate electrode with an insulating space between them, **characterized by** the fact that
- free-standing semiconductor columns (2) are grown vertically on a conductive substrate (1) ;
- a first insulating layer (3) is then deposited on the semiconductor columns (2);
- a first conductive metal layer (4) and a second insulating layer (5) are deposited thereon;
- the developing laminates is etched planar to the point of the portion of the first metal layer (4) covering the semiconductor columns (2) is removed again;
- the ends of the metal layer (4) penetrating to the surface of the laminate are etched back in a metal-specific manner a third insulating layer is deposited on the laminate with subsequent renewed planar etching;
or
the ends of the metal layer (4) penetrating to the surface of the laminate are converted to an insulator (6) by oxidizing or nitriding;
and
- finally depositing a second metal layer (7) on the laminate.

2. The method of claim 1,
**characterized by** the fact that
the laminate or individual layers are divided into arrays by a lithographic process.

3. The method of claim 1 or 2,
**characterized by** the fact that
the growing of the semiconductor columns is carried out electro-chemically.

4. The method of claim 1 or 2,
**characterized by** the fact that
the growing of the semiconductor columns is carried out by sputtering.

5. The method of claim 1 or 2,
**characterized by** the fact that
the growing of the semiconductor columns is carried out by a CVD process.

6. The method of claim 1 or 2,
**characterized by** the fact that
the growing of the semiconductor columns is carried out by vaporization.

7. The method of claim 1 or 2,
**characterized by** the fact that
the growing of the semiconductor columns is carried out on nucleation seeds.

8. The method of claim 1 or 2,
**characterized by** the fact that
the growing of the semiconductor columns is carried out in ion trace channels of a polymeric film which is subsequently removed.

## Revendications

1. Procédé pour fabriquer un transistor à effet de champ, sur lequel au moins une colonne à semi-conducteurs orientée verticalement avec un diamètre de l'ordre du nanomètre se trouve entre un contact source et un contact drain, laquelle colonne est entourée en forme de bague par un contact de porte sous charge d'une résistance d'isolement,
**caractérisé en ce que**
- des colonnes à semi-conducteurs (2) isolées sont installées verticalement d'abord sur un substrat (1) conducteur,
- ensuite une première couche isolante (3) est appliquée sur ces colonnes à semi-conducteurs (2),
- sur laquelle ensuite une première couche métallique (4) conductrice et une seconde couche isolante (5) sont appliquées,
- le corps de couche formé est décapé à plat jusqu'à ce que la fraction, recouvrant les colonnes à semi-conducteurs (2), de la première couche métallique (4) soit à nouveau enlevée,
- ensuite les extrémités de la couche métallique (4) traversant vers la surface du corps de couche sont rétrodécapées de façon spécifique au métal et une troisième couche isolante est appliquée sur le corps de couche, après quoi le corps de couche est décapé à nouveau à plat,
ou
les extrémités de la couche métallique (4), traversant vers la surface du corps de couche sont transformées par oxydation ou nitruration en un isolateur (6),
- et une seconde couche métallique (7) est appliquée pour finir sur le corps de couche.

2. Procédé selon la revendication 1,
**caractérisé en ce que**
les corps de couche ou des couches individuelles sont subdivisés au moyen d'une méthode lithographique en des agencements individuels.

3. Procédé selon la revendication 1 ou 2,
**caractérisé en ce que**
la croissance des colonnes à semi-conducteurs s'effectue de façon électrochimique.

4. Procédé selon la revendication 1 ou 2,
**caractérisé en ce que**
la croissance des colonnes à semi-conducteurs s'effectue par métallisation cathodique.

5. Procédé selon la revendication 1 ou 2,
**caractérisé en ce que**
la croissance des colonnes à semi-conducteurs s'effectue par un procédé CVD.

6. Procédé selon la revendication 1 ou 2,
**caractérisé en ce que**
la croissance des colonnes à semi-conducteurs s'effectue par évaporation.

7. Procédé selon la revendication 1 ou 2,
**caractérisé en ce que**
la croissance des colonnes à semi-conducteurs s'effectue par germination de nucléation.

8. Procédé selon la revendication 1 ou 2,
**caractérisé en ce que**
la croissance des colonnes à semi-conducteurs s'effectue dans des canaux de trace d'ions d'un film polymère, qui est ensuite à nouveau enlevé.
